# EUROPEAN PATENT APPLICATION

(11) **EP 1 005 152 A2**
(43) Date of publication of application: **31.05.2000**
(21) Application number: 99116696.8
(22) Date of filing: 26.08.1999
(51) Int. Cl.: H03H 9/17

(54) **Piezoelectric resonator, electronic component including the resonator and communication apparatus including the component**

(30) Priority: 25.11.1998 JP 33379198
(71) Applicant: Murata Manufacturing Co., Ltd., Nagaokakyo-shi Kyoto-fu 617-8555 (JP)
(72) Inventor: Unami, Toshihiko, c/o Murata Manufacturing Co.,Ltd, Nagaokakyo-shi, Kyoto-fu 617-8555 (JP)
(74) Representative: Laufhütte, Dieter, Dr.-Ing.

(57) **Abstract**

A piezoelectric resonator includes a base member having a rectangular parallelepiped shape. The base member comprises a large number of piezoelectric layers formed from a piezoelectric ceramic which are stacked. First and second inner electrodes are respectively formed on the main faces of each of the piezoelectric layers. Two external electrodes are formed on a side surface of the base member such that they are separated from each other in the transversal direction, and are connected to the first and second inner electrodes. When the overall dimension in a direction perpendicular to the main faces of the external electrodes is represented by W and a dimension of a gap portion where the first and second inner electrodes do not face each other is represented by g, g/W ≥ 0.1.

## Description

### BACKGROUND OF THE INVENTION

### Field of the Invention:

The present invention relates to a piezoelectric resonator, an electronic component including the resonator, and a communication apparatus including the electronic component. More particularly, the present invention relates to a piezoelectric resonator utilizing mechanical resonance of a piezoelectric body; an electronic component, such as a resonance component, a discriminator, or a filter, using the resonator; and a communication apparatus using such an electronic component.

### Description of the Related Art:

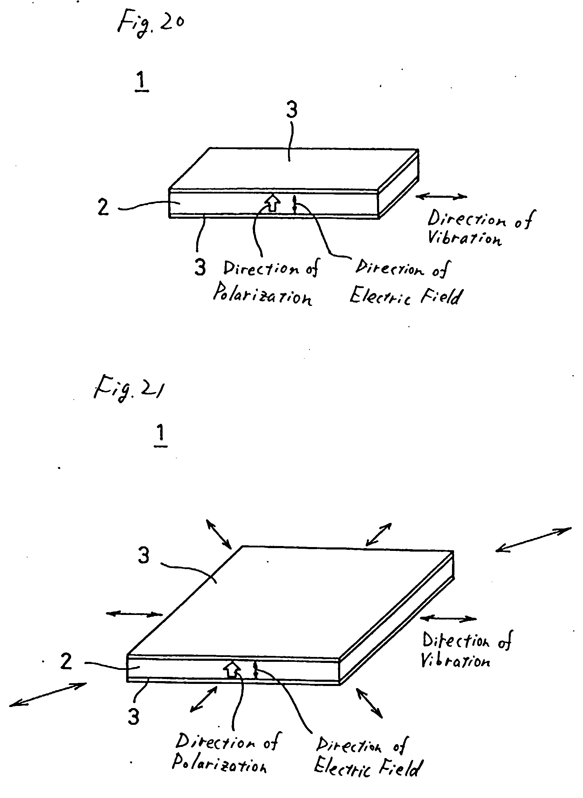

FIG. 20 is a perspective view showing a conventional piezoelectric resonator. The piezoelectric resonator 1 includes a piezoelectric substrate 2 having a rectangular plate-like shape. The piezoelectric substrate 2 is polarized in its thickness direction. An electrode 3 is formed on either face of the piezoelectric substrate 2. When a signal is input between the electrodes 3, an electric field is applied to the piezoelectric substrate 2 in the thickness direction thereof, so that the piezoelectric substrate 2 vibrates in the longitudinal direction. Further, a piezoelectric resonator as shown in FIG. 21 is also known. In the piezoelectric resonator 1 shown in FIG. 21 as well, an electrode 3 is formed on either face of a piezoelectric substrate 2 having a rectangular plate-like shape, and the piezoelectric substrate 2 is polarized in its thickness direction. In the piezoelectric resonator 1, when a signal is input between the electrodes 3, an electric field is applied to the piezoelectric substrate 2 in the thickness direction thereof, so that the piezoelectric substrate 2 vibrates in a square-type vibration mode.

These piezoelectric resonators are of unstiffened type, in which the direction of vibration differs from the direction of an electric field and the direction of polarization. The electromechanical coupling coefficient of such an unstiffened piezoelectric resonator is lower than that of a stiffened piezoelectric resonator in which the direction of vibration coincides with the direction of an electric field and the direction of polarization. Therefore, in a piezoelectric resonator utilizing the piezoelectric transversal effect, a difference ΔF between a resonance frequency and an antiresonance frequency is relatively small. When such a piezoelectric resonator is used as a resonance component or a filter, the small frequency difference results in a narrow bandwidth. Therefore, such a piezoelectric resonator and an electronic component using the same have limited freedom in design of their characteristics.

Although the piezoelectric resonator shown in FIG. 20 utilizes a fundamental harmonic of the longitudinal vibration, due to its structure, there are generated large spurious vibrations, such as odd harmonics (such as the third and fifth) of the longitudinal vibration, and a transversal vibration. Measures can be taken to suppress such spurious vibrations, such as performing a grinding operation on the piezoelectric resonator, attaching a mass to the piezoelectric resonator, or modifying the shape of the electrodes. However, these measures result in an increase in production costs.

Further, in the case of the piezoelectric resonator shown in FIG. 20 since the piezoelectric substrate has a rectangular plate-like shape, the thickness cannot be decreased very much, due to restriction in terms of stability. Therefore, the distance between the electrodes cannot be decreased, so that the capacitance between the terminals cannot be increased. This is extremely inconvenient when impedance matching is established between the resonator and an external circuit. Further, when a plurality of piezoelectric resonators are connected alternately in series and in parallel to thereby form a ladder-type filter, the ratio of the capacitance of a series resonator and that of a parallel resonator must be increased in order to increase the out-band attenuation. However, due to the above-described limitation in relation to the shape, in some cases, a large attenuation cannot be obtained.

Although the piezoelectric resonator shown in FIG. 21 utilizes a fundamental harmonic of the square vibration, due to its structure, there is a large possibility of generating large spurious vibrations, such as the third harmonic of the square vibration and thickness vibration. In addition, in order to obtain a certain resonance frequency, the size of the piezoelectric resonator must be made larger than that of a piezoelectric resonator utilizing longitudinal vibration, so that size reduction becomes difficult. When a ladder-type filter is formed through use of a plurality of piezoelectric resonators, there has been employed a technique in which, in order to increase the ratio of the capacitance of a series resonator and that of a parallel resonator, the thickness of a series resonator is increased and the electrodes of the series resonator are partially formed on the piezoelectric substrate in order to decrease the capacitance thereof. In this case, the employment of partial electrodes decreases not only the capacitance but also the difference ΔF between a resonance frequency and an antiresonance frequency. In order to cope with the decrease in the frequency difference, the difference ΔF of the parallel piezoelectric resonator must be decreased, resulting in difficulty in effectively utilizing the piezoelectric effect of the piezoelectric substrate and in increasing the bandwidth of the filter.

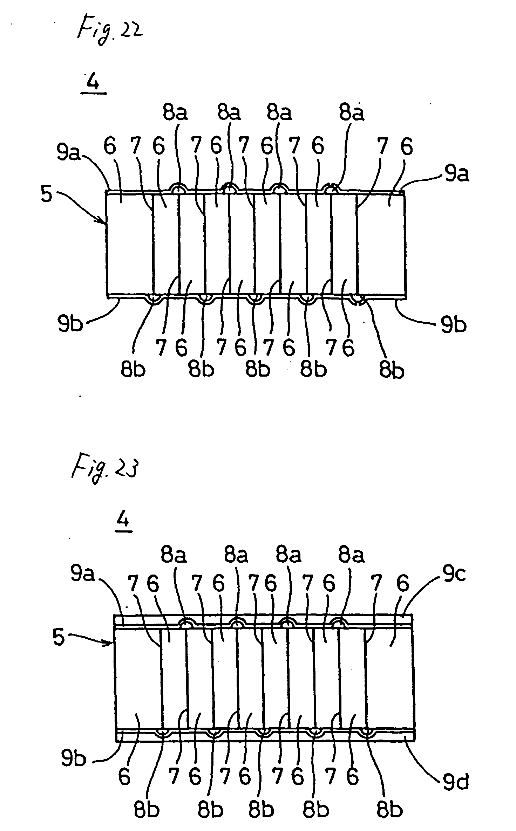

As disclosed in Japanese Patent Application No. 8-110475, the applicant of the present invention has proposed a layered piezoelectric resonator which produces suppressed spurious vibrations and in which the difference ΔF between a resonance frequency and an antiresonance frequency is large. FIG. 22 shows the structure of such a stacked piezoelectric resonator. In the stacked piezoelectric resonator 4 shown in FIG. 22, a plurality of piezoelectric layers 6 and a plurality of electrodes 7 are alternately stacked in order to form a base member 5, and the plurality of piezoelectric layers 6 are polarized in the longitudinal direction of the base member 5. The stacked piezoelectric resonator 4 excites a fundamental harmonic of the longitudinal vibration. Since the stacked piezoelectric resonator 4 is of stiffened type, in which the direction of vibration coincides with the direction of an electric field and the direction of polarization, the electromechanical coupling coefficient thereof becomes larger than that of an unstiffened piezoelectric resonator in which the direction of vibration differs from the direction of an electric field and the direction of polarization, and the difference ΔF between a resonance frequency and an antiresonance frequency increases. In addition, in the stacked piezoelectric resonator 4 of stiffened type, vibration of a mode that is different from the fundamental vibration, such as vibration of a transversal mode or thickness mode, becomes less likely to be generated.

In the stacked piezoelectric resonator 4, an end portion of each electrode 7 is exposed to the outside at each side surface of the base member 5. Therefore, on one side surface of the base member 5, the end portions of alternate electrodes 7 are coated with an insulating resin film 8a, and an external electrode 9a is formed to be connected to the remaining electrodes 7. Further, on the opposite side surface of the base member 5, the end portions of the electrodes 7 that are connected to the external electrode 9a are coated with an insulating resin film 8b, and an external electrode 9b is formed to be connected to the electrodes 7 whose opposite end portions are coated with an insulating resin film 8a. In the stacked piezoelectric resonator 4, the capacitance C between the external electrodes 9a and 9b is represented by C ∝ nS/T, where n represents the number of piezoelectric layers sandwiched between the electrodes 7, S represents the area of a cross section of the base member 5 along a direction perpendicular to the longitudinal axis thereof or the area of the main surface of the piezoelectric layer 6, and T represents the thickness of one piezoelectric layer 6 or the distance between the electrodes 7. Accordingly, when the area S is decreased to reduce the size of the piezoelectric element 4, it is possible to keep the capacitance C unchanged by decreasing T or increasing n. However, in a small piezoelectric resonator in which the distance between the electrodes 7 is not greater than 100 µm, the above-described insulating resin films 8a and 8b are difficult to form with sufficient positional accuracy, through printing or any other method. Therefore, the piezoelectric resonator 4 itself is difficult to render compact.

Further, in the stacked piezoelectric resonator 4, due to temperature variation such as heat shock or heat cycle in a subsequent process, the insulating resin films 8a and 8b expand and contract, so that the external electrodes 9a and 9b formed on the insulating resin films 8a and 8b may become broken, as shown in FIG. 22.

Moreover, piezoelectric resonators are required to have small variation in their characteristics.

### SUMMARY OF THE INVENTION

To overcome the above described problems, preferred embodiments of the present invention provide a piezoelectric resonator which can reduce spurious vibrations, which has a large difference between a resonance frequency and an antiresonance frequency, which can be made compact, whose external electrodes are durable, and whose characteristics show substantially no variation.

One preferred embodiment of the present invention provides a piezoelectric resonator comprising: a base member having a longitudinal direction; first and second internal electrodes disposed such that said first and second internal electrodes are separated from each other in the longitudinal direction of said base member and perpendicular to the longitudinal direction of said base member; a pair of external electrodes disposed on one side surface of said base member and connected to said first and second internal electrodes, one external electrode being located on one transversal side with respect to a transversal center of said base member, and the other external electrode being located on the other transversal side with respect to the transversal center; said base member comprising a plurality of stacked piezoelectric layers, said piezoelectric layers being polarized in the longitudinal direction of said base member; each of said first and second internal electrodes being disposed on a surface of said piezoelectric layer perpendicular to the longitudinal direction of said base member; said first internal electrode connected to one external electrode being provided such that said first inner electrode is not exposed from the one side surface at an area where the other external electrode is disposed; said second internal electrode connected to the other external electrode being provided such that said second internal electrode is not exposed from the one side surface at an area where said one external electrode is disposed; and g/W ≥ 0.1 being satisfied where the overall dimension in a direction perpendicular to the main surfaces of said external electrodes is represented by W and a dimension, measured in a direction perpendicular to the main surfaces of said external electrodes, of a gap portion where said first and second innner electrodes do not face each other is represented by g.

Another preferred embodiment of the present invention provides a piezoelectric resonator comprising: a base member having a longitudinal direction; first and second inner electrodes disposed such that said first and second inner electrodes are separated from each other in the longitudinal direction of said base member and perpendicular to the longitudinal direction of said base member; a pair of external electrodes disposed on two opposite side surfaces of said base member and connected to said first and second inner electrodes; said base member comprising a plurality of stacked piezoelectric layers, said piezoelectric layers being polarized in the longitudinal direction of said base member; each of said first and second inner electrodes being disposed on a surface of said piezoelectric layer perpendicular to the longitudinal direction of said base member; said first inner electrode connected to one external electrode is disposed such that said first inner electrode is not exposed from the two side surfaces at an area where the other external electrode is disposed; said second inner electrode connected to the other external electrode being disposed such that said second inner electrode is not exposed from the two side surfaces at an area where said one external electrode is disposed; and g/W ≥ 0.05 is satisfied where the overall dimension in a direction perpendicular to the main faces of said external electrodes is represented by W and a dimension, measured in a direction perpendicular to the main surfaces of said external electrodes, of a gap portion where said first and second inner electrodes do not face each other is represented by g.

Preferably, a plurality of first inner electrodes and a plurality of second inner electrodes are provided in the above described piezoelectric resonator.

Preferably, the above described piezoelectric resonator comprises a mount member disposed at the approximate center of the base member in the longitudinal direction thereof.

Yet another preferred embodiment of the present invention provides an electronic component including the above-described piezoelectric resonator, wherein the base member is attached, via the mount member, onto a substrate having an electrode disposed on the surface thereof, and a cap is disposed on the substrate to cover the base member.

In the above described electronic component, the piezoelectric resonator according to the present invention is preferably used as a parallel resonator of a ladder-type filter.

The above described electronic component may be a ladder-type filter.

Yet another preferred embodiment of the present invention provides a communication apparatus including a detector, wherein the piezoelectric resonator according to the present invention is used in the detector.

Yet another preferred embodiment of the present invention provides a communication apparatus including a detector, wherein the electronic component according to the present invention is used in the detector.

Yet another preferred embodiment of the present invention provides a communication apparatus including a bandpass filter, wherein the electronic component according to the present invention is used in the bandpass filter.

In the piezoelectric resonator according to the present invention, the direction of vibration coincides with the polarization direction of the piezoelectric layers and the direction of the electric field, and thus the piezoelectric resonator is of stiffened type. Therefore, the electromechanical coupling coefficient becomes higher than that of an unstiffened piezoelectric resonator in which the direction of vibration differs from the direction of an electric field and the direction of polarization, and the difference ΔF between a resonance frequency and an antiresonance frequency increases. In the stiffened piezoelectric resonator, generation of vibration of a mode that is different from the fundamental vibration, such as vibration of a transversal mode or thickness mode, is suppressed.

Further, in the piezoelectric resonator according to the present invention, the first inner electrode connected to one external electrode is disposed such that the first inner electrode is not exposed from the one side surface within an area where the other external electrode is disposed; and the second inner electrode connected to the other external electrode is disposed such that the second inner electrode is not exposed from the one side surface within an area where the one external electrode is disposed. Therefore, insulating resin film for insulating end portions of the first or second inner electrode is not required to be provided on the side surface of the base member, so that the distance between the first and second inner electrodes can be decreased in order to decrease the size of the piezoelectric resonator.

Moreover, in the piezoelectric resonator according to the present invention, since no insulating resin film is provided, the external electrodes are not broken due to variation in temperature such as heat shock or heat cycle.

In the piezoelectric resonator of the present invention, g/W ≥ 0.1 is satisfied where the overall dimension in a direction perpendicular to the main surfaces of the external electrodes is represented by W and a dimension, measured in a direction perpendicular to the main surfaces of the external electrodes, of a gap portion where the first and second inner electrodes do not face each other is represented by g. Alternatively, g/W ≥ 0.05 is satisfied where the overall dimension in a direction perpendicular to the main surfaces of the external electrodes is represented by W and a dimension, measured in a direction perpendicular to the main faces of the external electrodes, of a gap portion where the first and second inner electrodes do not face each other is represented by g. Therefore, even when the dimension of the gap portion changes, the fractional band width ΔF/Fr or the ratio of the difference Δ F between the resonance frequency and the antiresonance frequency and the resonance frequency Fr changes only to a small extent, so that variation in characteristics is small.

When a communication apparatus or an electronic component such as a resonance component, a discriminator, or a filter is fabricated from the piezoelectric resonator according to the present invention, the base member can be attached onto an electrode-bearing-substrate or the like via a mount member disposed at the approximate longitudinal center of the base member, so that the piezoelectric resonator can be reliably held at a node portion. Further, employment of the cap covering the substrate enables the electronic component to be fabricated as a chip-type component.

Other features and advantages of the present invention will become apparent from the following description of the invention which refers to the accompanying drawings.

### BRIEF DESCRIPTION OF THE DRAWINGS

FIG. 1 is an illustration showing one preferred embodiment of a piezoelectric resonator;
FIGS. 2A and 2B are plan views of first and second inner electrodes used in the piezoelectric resonator shown in FIG. 1;
FIG. 3 is a graph showing the relationship among g/W, d/W, and ΔF/Fr in the piezoelectric resonator shown in FIG. 1;
FIG. 4 is an illustration showing another preferred embodiment of the piezoelectric resonator;
FIG. 5A and 5B are plan views of first and second inner electrodes used in the piezoelectric resonator shown in FIG. 4;
FIG. 6 is a graph showing the relationship among g/W, d/W, and ΔF/Fr in the piezoelectric resonator shown in FIG. 4;
FIG. 7 is an illustration showing an exemplary electronic component using the piezoelectric resonator shown in FIG. 1;
FIG. 8 is a side view showing the mounting structure of the piezoelectric resonator in the electronic component shown in FIG. 7;
FIG. 9 is an illustration showing another exemplary electronic component using the piezoelectric resonator shown in FIG. 4;
FIG. 10 is a side view showing the mounting structure of the piezoelectric resonator in the electronic component shown in FIG. 9;
FIG. 11 is a plan view of a main portion of a ladder-type filter, which is an exemplary electronic component using the piezoelectric resonator shown in FIG. 1;
FIG. 12 is an exploded perspective view of a main portion of the ladder-type filter shown in FIG. 11;
FIG. 13 is an illustration of another piezoelectric resonator used in the ladder-type filter shown in FIG. 11;
FIG. 14 is a circuit diagram of the ladder-type filter shown in FIG. 11;
FIG. 15 is a plan view of a main portion of a ladder-type filter, which is an exemplary electronic component using the piezoelectric resonator shown in FIG. 4;
FIG. 16 is an exploded perspective view of a main portion of the ladder-type filter shown in FIG. 15;
FIG. 17 is an illustration of another piezoelectric resonator used in the ladder-type filter shown in FIG. 15;
FIG. 18 is a circuit diagram of the ladder-type filter shown in FIG. 15;
FIG. 19 is a block diagram showing an example of a double-super-heterodyne receiver according to the present invention;
FIG. 20 is a perspective view of a prior art piezoelectric resonator;
FIG. 21 is a perspective view of another prior art piezoelectric resonator;
FIG. 22 is an illustration of a stacked piezoelectric resonator, which serves as the background art of the present invention; and
FIG. 23 is an illustration showing a state in which a conductive resin layer is formed on the surface of the external electrodes of the piezoelectric resonator shown in FIG. 22.

### DESCRIPTION OF THE PREFERRED EMBODIMENTS

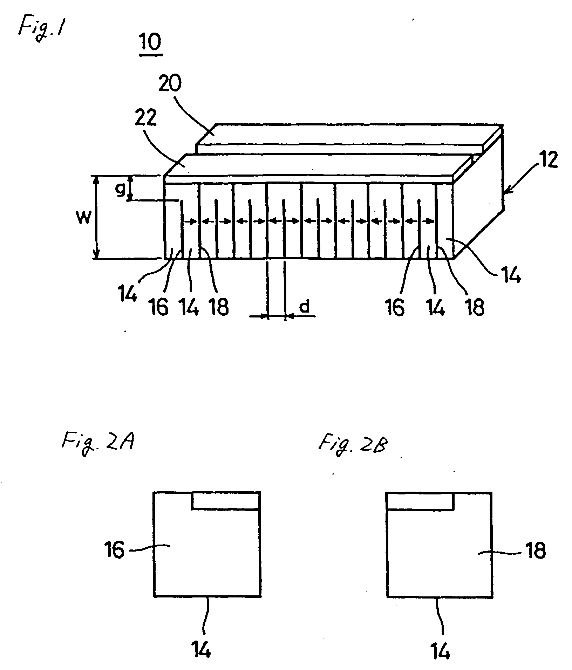

Referring to FIG. 1, a piezoelectric resonator 10 comprises a base member 12 having a rectangular parallelepiped shape. The base member 12 comprises a large number of piezoelectric layers 14 formed from a piezoelectric ceramic which are stacked. The piezoelectric layers 14 are provided to have the same dimensions. Further, among the piezoelectric layers 14, intermediate piezoelectric layers 14 are polarized in the longitudinal direction of the base member 12 such that, as indicated by arrows in FIG. 1, the polarization directions of adjacent piezoelectric layers 14 become opposite each other.

First and second inner electrodes 16 and 18 are respectively provided on the main surfaces of each of the polarized intermediate piezoelectric layers 14, with their main surfaces perpendicularly intersecting the longitudinal direction of the base member 12. Accordingly, the first and second inner electrodes 16 and 18 perpendicularly intersect the longitudinal direction of the base member 12 and are spaced from each other in the longitudinal direction of the base member 12. Further, as shown in FIG. 2A, the first inner electrode 16 is provided on one main surface of the piezoelectric layer 14 except within an area extending from the center portion of an upper side to one end thereof; and as shown in FIG. 2B, the second inner electrode 18 is provided on the other main surface of the piezoelectric layer 14 except within an area extending from the center portion of the upper side to the other end thereof. Therefore, the first inner electrode 16 is formed such that, on an upper side surface of the base member 12, the first inner electrode 16 is not exposed in an area extending from a transversal center to a first transversal end but is exposed at a second transversal end. Similarly, the second inner electrode 18 is formed such that, on the upper side surface of the base member 12, the second inner electrode 18 is exposed at the first transversal end but is not exposed within an area extending from the transversal center to the second transversal end.

Two external electrodes 20 and 22 are disposed on the upper side surface of the base member 12 along the longitudinal direction thereof. The external electrode 20 is located on one transversal side with respect to a transversal center of the base member 12, whereas the external electrode 22 is located on the other transversal side with respect to the transversal center of the base member 12. The external electrode 20 is connected to the first inner electrodes 16, and the external electrode 22 is connected to the second inner electrodes 18.

The piezoelectric resonator 10 shown in FIG. 1 is formed such that the overall dimension in the longitudinal direction is 4.5 mm; the overall dimension W in the direction perpendicular to the main faces of the external electrodes 20 and 22 is 0.5 mm; the overall dimension in the direction in which the external electrodes 20 and 22 are disposed side by side is 0.7 mm; the distance between the first and second inner electrodes 16 and 18 or the interlayer distance d is 0.11 mm; and the dimension g of a gap which is measured in the direction perpendicular to the main surfaces of the external electrodes 20 and 22 and where the first and second inner electrodes 16 and 18 do not face each other is 0.1 mm. It is to be noted that in FIG. 1, some of the piezoelectric layers 14, some of the first inner electrodes 16, and some of the second inner electrodes 18 are omitted.

In the piezoelectric resonator 10, the external electrodes 20 and 22 are used as input and output electrodes. When a signal is applied between the external electrodes 20 and 22, an electric field is created between the first and second inner electrodes 16 and 18 adjacent each other, so that piezoelectric layers 14 other than the piezoelectric layers 14 located at the ends of the base member (i.e., only intermediate piezoelectric layers 14) are piezoelectrically activated. In this case, since voltages having opposite polarities are applied to two adjacent piezoelectric layers 14 of the base member 12 polarized in opposite directions, all the piezoelectric layers 14 tend to expand and contract in the same direction. That is, when an AC electric field is applied along the longitudinal direction of the base member 12 by means of the first and second inner electrodes 16 and 18 connected to the external electrodes 20 and 22 to thereby generate a drive force in each piezoelectric layer 14 for inducing expansion and contraction motion, in the piezoelectric resonator 10 as a whole, the fundamental harmonic of longitudinal vibration is excited such that the longitudinal center of the base member 12 serves as a node.

In the piezoelectric resonator 10, the polarization direction of the piezoelectric layers 14, the direction of the electric field created by the input signal, and the vibration direction of the piezoelectric layers 14 coincide with one another. In other words, the piezoelectric resonator 10 serves as a piezoelectric resonator of stiffened type. The piezoelectric resonator 10 has a higher electromechanical coupling coefficient as compared with an unstiffened piezoelectric resonator in which the direction of vibration differs from the polarization direction and the electric field direction. Therefore, in the piezoelectric resonator 10, the difference ΔF between a resonance frequency and an antiresonance frequency is larger than that of the conventional piezoelectric resonator of unstiffened type. Accordingly, in the piezoelectric resonator 10, a wider bandwidth can be obtained as compared with the conventional piezoelectric resonator of unstiffened type.

Further, in the piezoelectric resonator 10, in contrast to the layered piezoelectric resonator 4 shown in FIG. 22, the first inner electrode 16 connected to one external electrode 20 is provided not to be exposed at a first transversal end of one side surface of the base 12 where the other external electrode 22 is disposed; and the second inner electrode 18 connected to the external electrode 22 is provided not to be exposed at a second transversal end of the side surface of the base 12 where the external electrode 20 is disposed. Therefore, insulating resin film for insulating end portions of the first and second inner electrodes 16 and 18 are not required to be formed on the side surface of the base 12. Therefore, the distance between the first and second inner electrodes 16 and 18 can be decreased, so that the piezoelectric resonator 10 can be easily made compact.

Further, unlike the layered piezoelectric resonator 4 shown in FIG. 22, in the piezoelectric resonator 10, since no insulating resin film is formed between the external electrodes 20 and 22 and the base member 12, the external electrodes 20 and 22 become more durable to temperature variation such as heat shock or heat cycle.

In the layered piezoelectric resonator 4 shown in FIG. 22, in order to prevent breakage of the external electrodes 9a and 9b on the insulating resin films 8a and 8b, conductive resin layers 9c and 9d may be formed on the surface of the external electrodes 9a and 9b, as shown in FIG. 23. However, when the insulating resin films 8a and 8b or the conductive resin layers 9c and 9d are formed, a heavy load mass is formed on a side surface of the base member 5, resulting in deterioration in mechanical quality factor Qm and increased voltage dependency of the resonant frequency. By contrast, in the piezoelectric resonator 10, since a load mass such as an insulating resin film or a conductive resin layer is not formed on a side surface of the base member 12, the mechanical quality factor Qm is not deteriorated, and the voltage dependency of the resonant frequency does not increase.

Moreover, in the piezoelectric resonator 10, since the ratio g/W is 0.2 and greater than 0.1, variation in the dimension g of the gap portion causes reduced variation in the fractional band width ΔF/Fr or the ratio of the difference ΔF between the resonance frequency and the antiresonance frequency and the resonance frequency Fr, and reduced variation in characteristics.

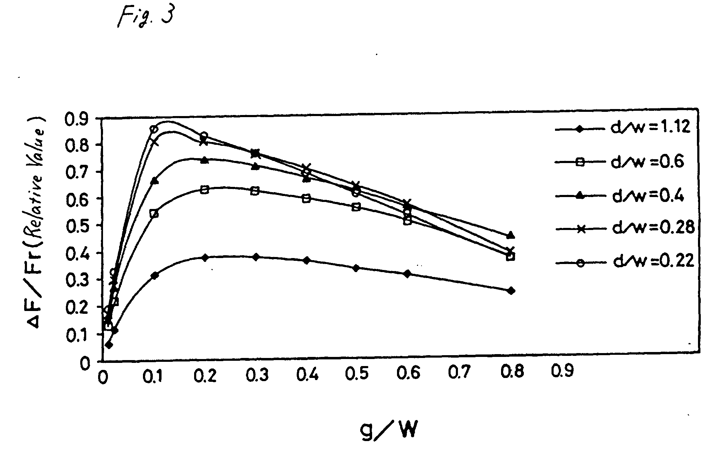

That is, the piezoelectric resonator 10 shows a relationship among the ratios g/W, d/W, and ΔF/Fr as shown in the graph of FIG. 3.

Specifically, for each value of the ratio d/W, in a region where g/W ≥ 0.1, the ratio ΔF/Fr decreases gradually with an increase in the ratio g/W. The reason for this phenomenon is as follows: at the gap portion, drive force due to the piezoelectric effect is not generated, so that longitudinal vibration is prevented mechanically, and when the gap increases, the efficiency of piezoelectric excitation decreases.

Meanwhile, in a region where g/W <0.1, the slope of a curve is steep, so that when the ratio g/W decreases, the ratio ΔF/Fr decreases drastically. The reason for this phenomenon is as follows: when the dimension g of the gap portion decreases, the capacitance between the first and second inner electrodes 16 and 18 and the external electrodes 20 and 22 increases drastically, with the result that a capacitance that does not contribute to piezoelectric excitation is added in parallel to the piezoelectric resonator 10.

In manufacture of the piezoelectric resonator, the size of the gap portion may vary to some extent. In the region where the slope of the curve is steep, the ratio Δ F/Fr varies greatly with the size g of the gap portion, resulting in variation in characteristics.

By contrast, when the ratio g/W is set to 0.2, which is greater that 0.1, the variation in the ratio ΔF/Fr caused due to variation of the dimension g of the gap portion can be made relatively small as compared with the case where the ratio g/W is less than 0.1, and variation in characteristics can also be made relatively small.

In the region of g/W ≥ 0.1 in the graph shown in FIG. 3, the ratio ΔF/Fr increases as the ratio d/W decreases. The reason for this phenomenon is as follows: When d/W is small i.e., d is small, the capacitance between the first and the second inner electrodes 16 and 18 increases. Therefore, the affections by the capacitance between first inner electrodes 16 and the external electrodes 20, and by the capacitance between first inner electrodes 18 and the external electrodes 22 become relatively low.

Further, in the piezoelectric resonator 10, even if the widthwise dimension of the resonator is decreased, while the width of the portion where neither the first inner electrode 16 nor the second inner electrodes 18 is formed on the main surfaces of the piezoelectric layer 14 is maintained constant in order to secure insulation at the end portions of the first and second inner electrodes 16 and 18, the ratio of an area over which the first and second inner electrodes 16 and 18 face each other to the area of the main faces of the piezoelectric layer 14 does not change, so that the width of the piezoelectric resonator 10 can be decreased without no decrease in the efficiency of generating drive force in the piezoelectric layer 14.

Further, in the piezoelectric resonator 10, since the first and second inner electrodes 16 and 18 are partially formed on the main surfaces of the piezoelectric layer 14, the frequency difference ΔF can be adjusted through adjustment of the area over which the first and second inner electrodes 16 and 18 face each other, thereby providing a high degree of freedom in design of the characteristics.

Moreover, the electrical capacitance of the piezoelectric resonator 10 can be adjusted through adjustment of, for example, the area over which the first and second inner electrodes 16 and 18 face each other, the number of the piezoelectric layers 14 and the first and second inner electrodes 16 and 18, and the size of the piezoelectric layers 14 in the longitudinal direction of the base member 12. That is, the electrical capacitance of the piezoelectric resonator 10 can be increased through an increase in the area over which the first and second inner electrodes 16 and 18 face each other, an increase in the number of the piezoelectric layers 14 and the first and second inner electrodes 16 and 18, or a decrease in the size of the piezoelectric layers 14 in the longitudinal direction of the base member 12. In contrast, the electrical capacitance of the piezoelectric resonator 10 can be decreased through a decrease in the area over which the first and second inner electrodes 16 and 18 face each other, a decrease in the number of the piezoelectric layers 14 and the first and second inner electrodes 16 and 18, or an increase in the size of the piezoelectric layers 14 in the longitudinal direction of the base member 12. Therefore, a high degree of freedom in design of the electronic capacitance is attained, so that an impedance matching with an external circuit can be easily established when the piezoelectric resonator 10 is mounted on a circuit board or the like.

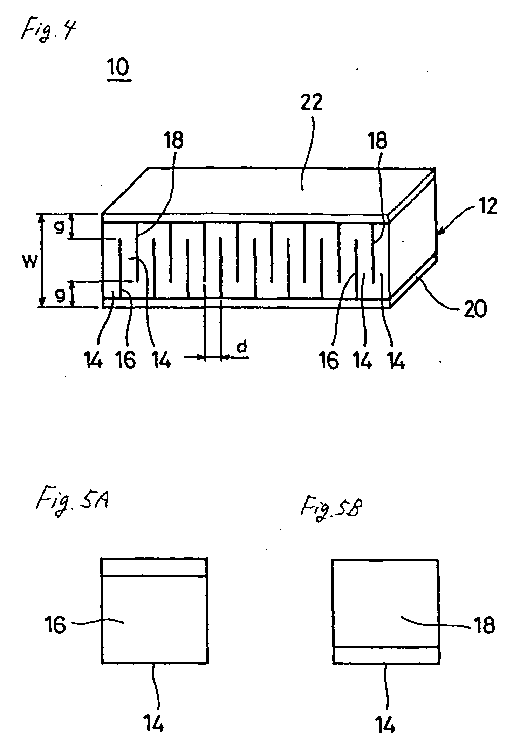

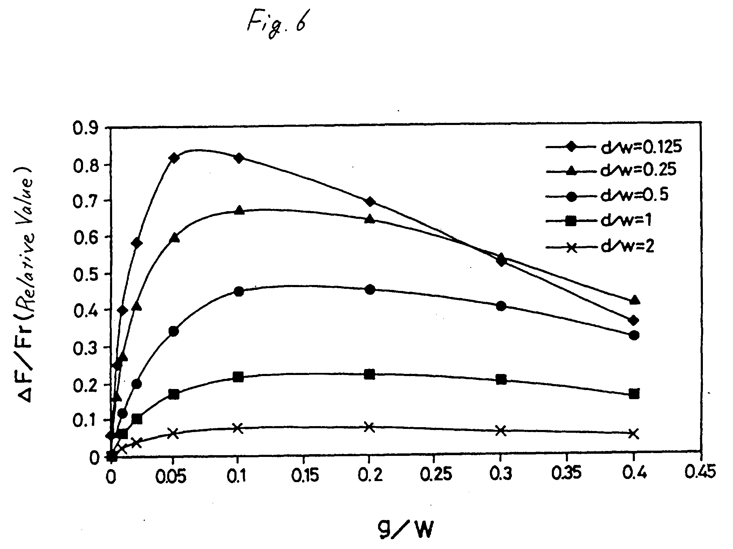

Referring to FIG.4, the piezoelectric resonator 10 differs from the piezoelectric resonator 10 shown in FIG. 1 only in terms of the shapes and structures of the first and second inner electrodes 16 and 18 and the external electrodes 20 and 22. That is, in the piezoelectric resonator 10 shown in FIG. 4, the first inner electrode 16 is formed on one main surface of the piezoelectric layer 14 except the upper end portion thereof, as shown in FIG. 5A, and the second inner electrode 18 is formed on the other main surface of the piezoelectric layer 14 except the lower end portion thereof, as shown in FIG. 5B. The external electrode 20 is formed on the lower surface of the base member 12 and is connected to the first inner electrode 16. The external electrode 22 is formed on the upper surface of the base member 12 and is connected to the second inner electrode 18.

Further, in contrast with the case of the piezoelectric resonator 10 shown in FIG. 1, in the piezoelectric resonator 10 shown in FIG. 4, the overall dimension W in the direction perpendicular to the main surfaces of the external electrodes 20 and 22 is 0.7 mm; and the dimension g of a gap portion which is measured in the direction perpendicular to the main faces of the external electrodes 20 and 22 and where the first and second inner electrodes 16 and 18 do not face each other is 0.1 mm.

In FIG. 4 as well, some of the piezoelectric layers 14, some of the first inner electrodes 16, and some of the second inner electrodes 18 are omitted.

Especially, the piezoelectric resonator 10 shown in FIG. 4 differs from the piezoelectric resonator 10 shown in FIG. 1 in that the center line or center point of a rectangular shape formed through superposition of the first and second inner electrodes 16 and 18 coincides with the center line or center point of a cross section of the base member 12 perpendicular to the longitudinal axis thereof. Therefore, the drive force generated in the piezoelectric layer 14 does not deviate from the center axis of the base member 12, so that the base member 12 undergoes substantially no flexing, and thus no spurious vibration is generated.

Moreover, in the piezoelectric resonator 10 shown in FIG. 4, since the ratio g/W is about 0.14 and is greater than 0.05, variation in the dimension g of the gap portion causes reduced variation in the fractional bandwidth ΔF/Fr, and reduced variation in characteristics.

That is, in the piezoelectric resonator 10 shown in FIG. 4, as is apparent from the relationship among g/W, d/W, and ΔF/Fr shown in the graph of FIG. 6, when the ratio g/W is not less than 0.05, variation in the fractional bandwidth ΔF/Fr and variation in characteristics are small even if the dimension g of the gap portion changes.

The above-described piezoelectric resonator 10 is constructed such that a longitudinally intermediate portion of the base member 12 comes into a piezoelectrically active state and vibrates, and opposite longitudinal ends of the base 12 are formed of inactive portions that never come into a piezoelectrically active state. A piezoelectric layer comes into a piezoelectrically active state only when the piezoelectric layer is polarized and an electric field is applied thereto. Otherwise, the piezoelectric layer comes into a piezoelectrically inactive state. The nature of the inactive portions is such that they never come into a piezoelectrically active state.

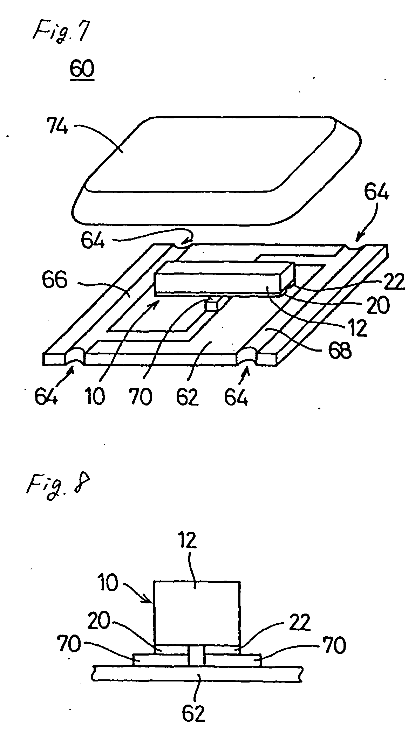

Electronic components such as a resonance component and a discriminator are fabricated through use of the above-described piezoelectric resonator 10. FIG. 7 is an illustration of an exemplary electronic component 60 in which the piezoelectric resonator 10 shown in FIG. 1 is used. The electronic component 60 shown in FIG. 7 comprises an insulating substrate 62 serving as a support member. Two depressions 64 are formed in each of opposite end portions of the insulating substrate 62. Two pattern electrodes 66 and 68 are formed on one main face of the insulating substrate 62. One pattern electrode 66 is formed between a set of opposite depressions 64, and a branch portion is branched from one end of the pattern electrode 66 such that the branch portion extends toward the center portion of the insulating substrate 62, while forming a L-like shape. Similarly, the other pattern electrode 68 is formed between the other set of opposite depressions 64, and a branch portion is branched from one end of the pattern electrode 68, which is opposite the one end of the pattern electrode 66, such that the branch portion extends toward the center portion of the insulating substrate 62, while forming a L-like shape. These pattern electrodes 66 and 68 are formed such that they extend to the other main surface of the insulating substrate 62 via the depressions 64. A commonly-used substrate such as a glass epoxy substrate or alumina substrate may be used as the insulating substrate 62. Further, the insulating substrate 62 may be a multi-layer substrate or a dielectric substrate.

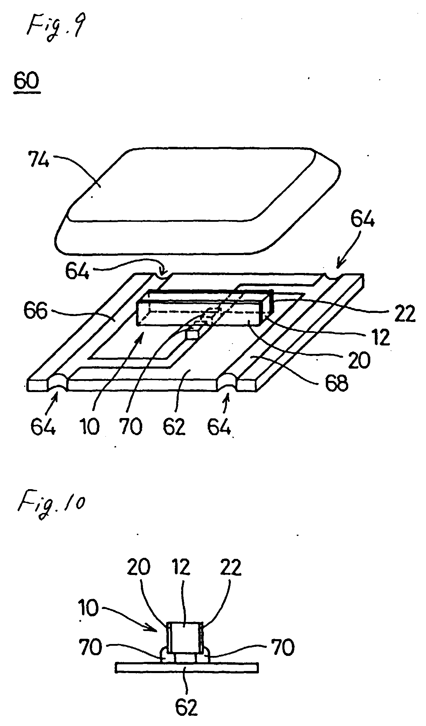

At the longitudinal center portion of the base member 12 corresponding to the longitudinal center portion of the piezoelectric resonator 10 are provided projections 70 each formed from a conductive material, such as a conductive adhesive, serving as a mount member. As shown in FIG. 8, the piezoelectric resonator 10 is mounted on the pattern electrodes 66 and 68 of the insulating substrate 62 via the projections 70. At this time, the external electrodes 20 and 22 of the piezoelectric resonator 10 are respectively connected to the pattern electrodes 66 and 68 via the projections 70. An adhesion used for bonding the projections 70 may be applied on the pattern electrodes 66 and 68 of the insulating substrate 62.

Further, as shown in FIG. 7, a metal cap 74 is attached onto the insulating substrate 62. An insulating resin is applied onto the pattern electrodes 66 and 68 in order to prevent the metal cap 74 from coming into electrical contact with the pattern electrodes 66 and 68 upon attachment of the cap 74. Upon attachment of the metal cap 74, the electronic component 60 is completed. In the electronic component 60, the pattern electrodes 66 and 68 that are formed to extend to the reverse surface via the depressions 64 are used as input/output terminals for connection with an external circuit.

In the electronic component 60, since the projections 70 are formed at the center portion of the piezoelectric resonator 10, the center portion of the piezoelectric resonator 10 serving as a node point can be reliably supported, so that the projections 70 do not hinder excited longitudinal vibration.

The electronic component 60 is attached to a circuit board together with ICs and other components and is used as a resonance component or a discriminator. In the electronic component 60 having the above-described structure, since the metal cap 74 seals and protects the component 60, the component 60 can be used as a chip component that can be attached through re-flow of solder.

When the electronic component 60 is used as a resonance component, use of the above-described piezoelectric resonator 10 suppresses spurious vibration, so that abnormal oscillation stemming from spurious vibration can be prevented. Further, since the capacitance of the piezoelectric resonator 10 can be set freely, impedance matching with an external circuit can be easily attained. Especially, when the piezoelectric resonator 10 is used as a resonance component of a voltage-controlled oscillator, the large frequency difference ΔF of the resonance component enables operation within a wider frequency variation range as compared with conventionally attained frequency variation ranges.

Further, when the electronic component 60 is used as a discriminator, the large frequency difference ΔF of the resonance component enables a wider peak separation. Moreover, since the capacitor of the piezoelectric resonator can be designed within a wider range, impedance matching with an external circuit can be easily established.

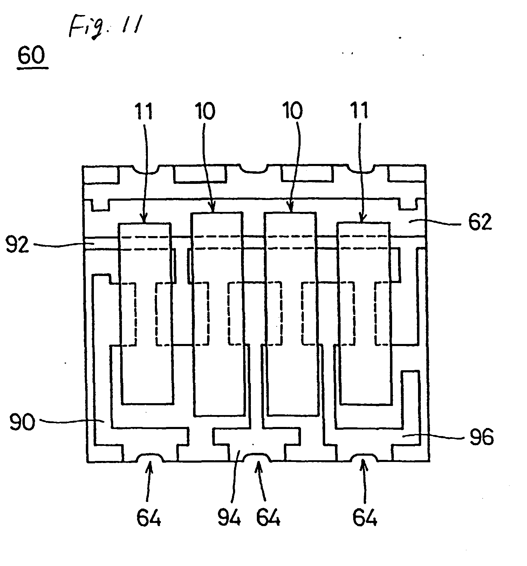

FIG. 9 is an illustration showing another exemplary electronic component 60 using the piezoelectric resonator 10 shown in FIG. 4. FIG. 10 is a side view showing the mounting structure of the piezoelectric resonator 10 in the electronic component 60 shown in FIG. 9. The electronic component 60 shown in FIG. 9 differs from the electronic component 60 shown in FIG. 7 in that the piezoelectric resonator 10 shown in FIG. 4 is used in place of the piezoelectric resonator 10 shown in FIG. 1.

The electronic component 60 shown in FIG. 9 achieves the same effects as those achieved by the electronic component 60 shown in FIG. 7.

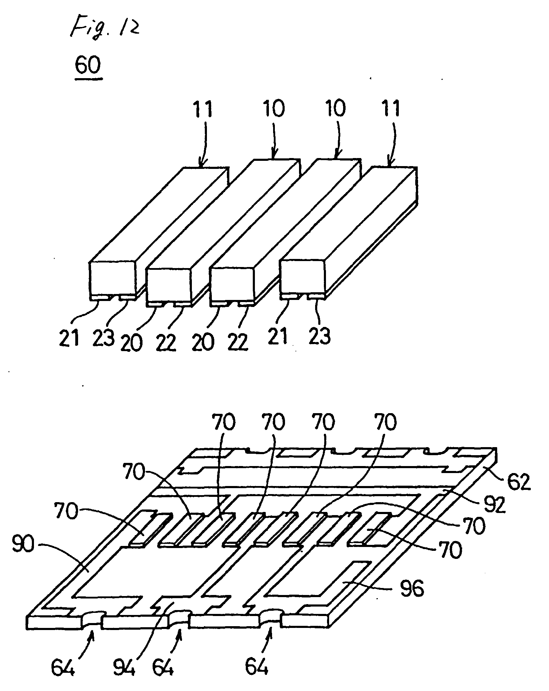

FIG. 11 is a plan view of a main portion of a ladder-type filter, which is an exemplary electronic component 60 using the piezoelectric resonator 10 shown in FIG. 1; and FIG. 12 is an exploded perspective view of a main portion of the ladder-type filter shown in FIG. 11. In the electronic component 60 shown in FIGS. 11 and 12, four pattern electrodes 90, 92, 94, and 96 are formed on the insulating substrate 62 serving as a support member. Five lands are formed on these patterns 90-96 such that the lands are separated from one another and are aligned in a line. In this case, as counted from one end of the insulating substrate 62, the first land is formed on the pattern electrode 90; the second and fifth lands are formed on the pattern electrode 92, the third land is formed on the pattern electrode 94, and the fourth land is formed on the pattern electrode 96.

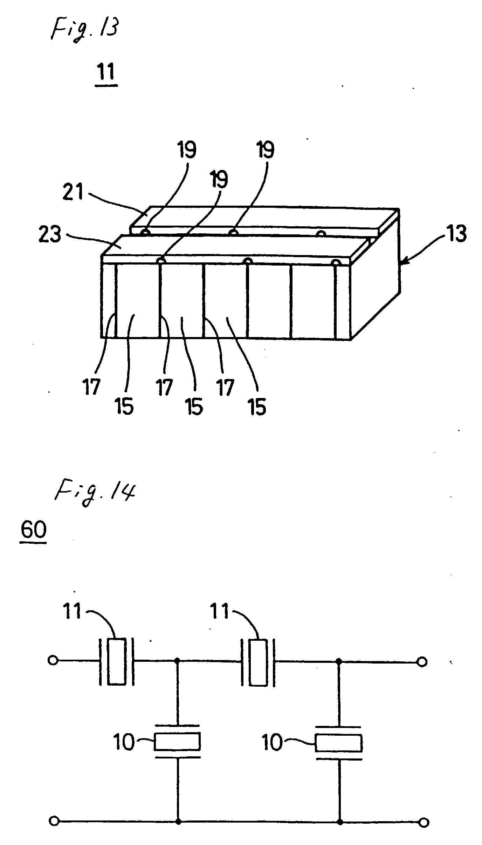

External electrodes 20, 21, 22, and 23 of four piezoelectric resonators 10 and 11 are attached to the pattern electrodes 90-96. A piezoelectric resonator as shown in FIG. 1, in which external electrodes 20 and 22 are formed on one side surface of a base member 12, is used as each of the piezoelectric resonators 10. Each of the piezoelectric resonators 11 is a piezoelectric resonator as shown in FIG. 13, in which external electrodes 21 and 23 are formed on one side surface of a base member 13.

In the piezoelectric resonator 11 shown in FIG. 13, a plurality of piezoelectric layers 15 and a plurality of electrodes 17 are alternately stacked in order to form the base member 13, and the plurality of piezoelectric layers 15 are polarized in the longitudinal direction of the base member 13 such that the polarization directions of adjacent piezoelectric layers 15 become opposite each other. On one side surface of the base member 13, the end portions of alternate electrodes 17 are coated, at one traverse end, with an insulating resin film 19, and the external electrode 21 is connected to the remaining electrodes 17. Further, at the other traverse end, the end portions of the electrodes 17 that are connected to the external electrode 21 are coated with an insulating resin film 19, and the external electrode 23 is connected to the remaining electrodes 17.

When the piezoelectric resonators 10 and 11 are attached onto the pattern electrodes 90-96, the external electrodes 20, 21, 22, and 23 of the piezoelectric resonators 10 and 11 are attached to the pattern electrodes 90-96 of the insulating substrate 62 via the projections 70 serving as mount members. Subsequently, a metal cap (not shown) is disposed on the insulating substrate 62 in order to cover the insulating substrate 62.

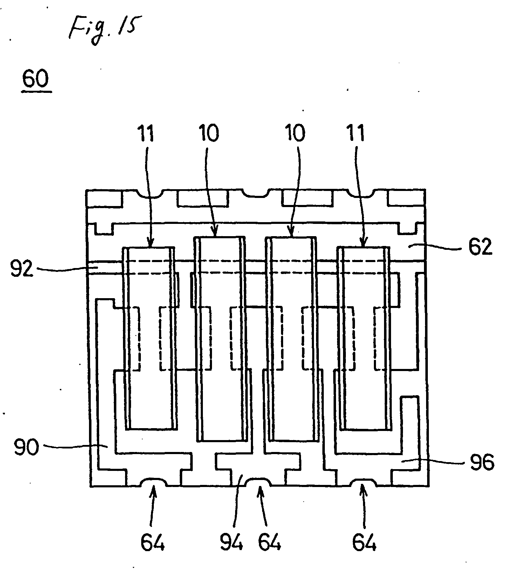

The electronic component 60 shown in FIGS. 11 and 12 is used as a ladder-type filter having a ladder-type circuit as shown in FIG. 14. In the circuit, the two piezoelectric resonators 10 are used as parallel resonators, and the two piezoelectric resonators 11 are used as series resonators. In such a ladder-type filter, the attenuation in the inhibition range is determined on the basis of the ratio of the capacitance of the parallel resonators to the capacitance of the series resonators, and the parallel resonators 10 are designed to have a capacitance greater than that of the series resonators 11. In this case, a piezoelectric resonator in which the number of stacked piezoelectric layers is increased through reduction of the interlayer distance is used for the parallel resonators, and a piezoelectric resonator in which the number of stacked piezoelectric layers is decreased through increase of the interlayer distance is used for the series resonators. Further, the pass bandwidth of the ladder-type filter is determined depending on ΔF of each resonator, and the value of ΔF of the parallel resonators is set to substantially the same value as the value of ΔF of the series resonators. When the piezoelectric resonator shown in FIG. 1 and having a gap is used for the series resonators, the interlayer distance increases as shown in FIG. 3, so that the value of ΔF decreases. Therefore, the piezoelectric resonator 11 shown in FIG. 13 and having no gap is used. In the case of series resonators, since the interlayer distance is large, the above-described problem in relation to formation of insulating film does not occur.

The attenuation of the ladder-type filter depends on the capacitance ratio between the series resonators and the parallel resonators. In the electronic component 60 shown in FIGS. 11 and 12, the capacitance of each of the piezoelectric resonators 10 and 11 is adjusted through a change in the number of stacked piezoelectric layers or the like. Accordingly, through adjustment of the capacitances of the piezoelectric resonators 10 and 11, there can be realized a ladder-type filter that attains a larger attenuation, through use of a fewer number of resonators, as compared to the case where conventional piezoelectric resonators utilizing a piezoelectric transversal effect are used. Further, since the value of ΔF of the piezoelectric resonators 10 and 11 is higher than that of conventional piezoelectric resonators, the pass bandwidth becomes wider than that of a filter utilizing conventional piezoelectric resonators.

Further, in the electronic component 60 shown in FIGS. 11 and 12, since two electrodes of adjacent piezoelectric resonators are attached to a common land, provision of insulation is not required between the two electrodes of adjacent piezoelectric resonators. Therefore, adjacent piezoelectric resonators can be disposed closer in order to reduce the size of the filter.

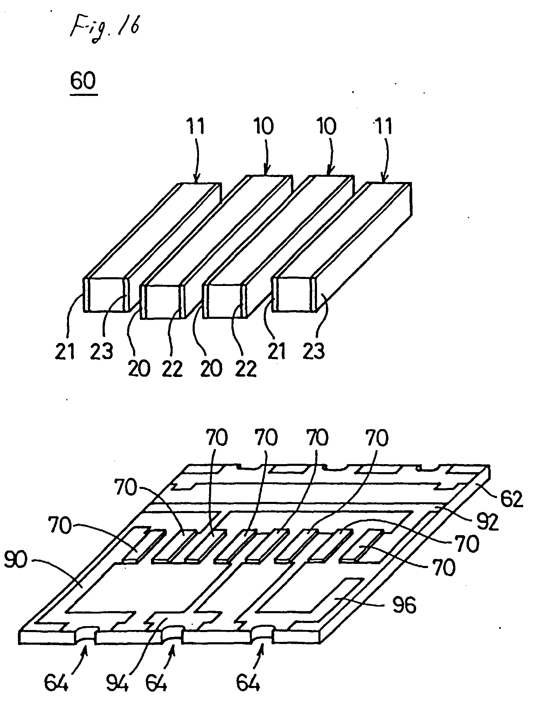

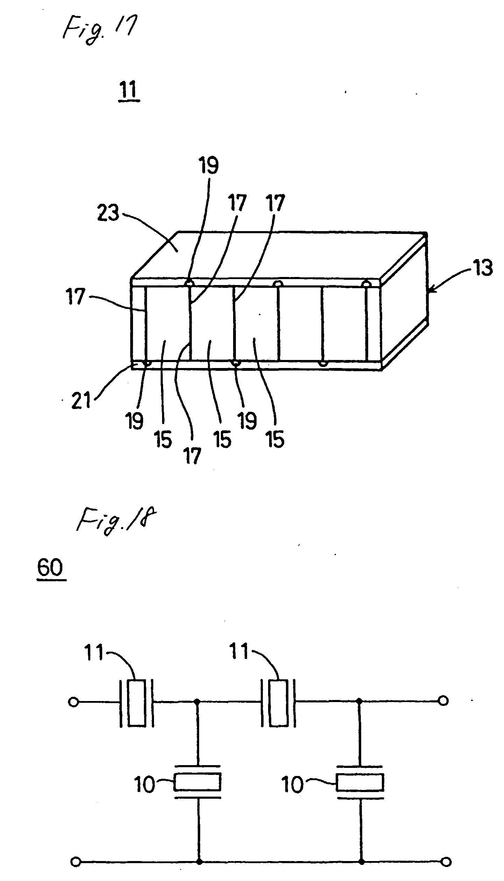

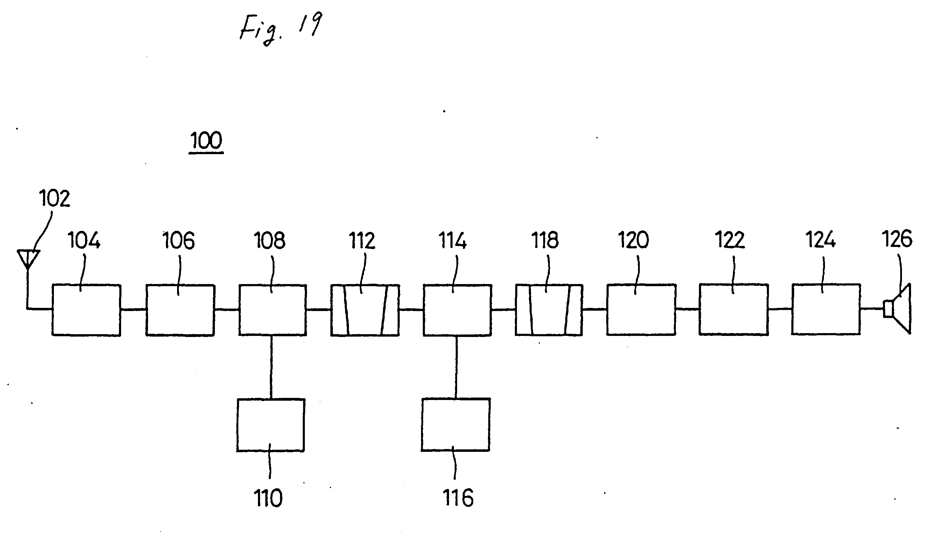

FIG. 15 is a plan view of a main portion of a ladder-type filter, which is an exemplary electronic component 60 using the piezoelectric resonator 10 shown in FIG. 4. FIG. 16 is an exploded perspective view of a main portion of the ladder-type filter shown in FIG. 15. The electronic component 60 shown in FIGS. 15 and 16 differs from the electronic component 60 shown in FIGS. 11 and 12 in that the piezoelectric resonator 10 shown in FIG. 4 is used for parallel resonators, and the piezoelectric resonator 11 shown in FIG. 17 is used for series resonators. In the case of series resonators, since the interlayer distance is large, the above-described problem in relation to formation of insulating film does not occur.

In the piezoelectric resonator 11 shown in FIG. 17, a plurality of piezoelectric layers 15 and a plurality of electrodes 17 are alternately stacked in order to form a base member 13, and the plurality of piezoelectric layers 15 are polarized in the longitudinal direction of the base member 13 such that the polarization directions of adjacent piezoelectric layers 15 become opposite each other. On the lower surface of the base member 13, the end portions of alternate electrodes 17 are coated with an insulating resin film 19, and the external electrode 21 is connected to the remaining electrodes 17. Further, on the upper surface, the end portions of the electrodes 7 that are connected to the external electrode 21 are coated with an insulating resin film 19, and the external electrode 23 is connected to the remaining electrodes 17.

The electronic component 60 shown in FIGS. 15 and 16 is used as a ladder-type filter having a ladder-type circuit as shown in FIG. 18. The electronic component 60 shown in FIGS. 15 and 16 achieves the same effects as those achieved by the electronic component 60 shown in FIGS. 11 and 12.

Although the above-described electronic components are formed in a chip shape, the electronic components of the present invention may have a shape other than the chip shape.

In each of the above-described piezoelectric resonators 10, the plurality of piezoelectric layers 14 are alternately polarized in opposite directions. However, the direction of polarization of the plurality of piezoelectric layers 14 is not limited thereto.

In the piezoelectric resonators 10, the dimension of each piezoelectric layer 14 in the longitudinal direction of the base member 12 or the distance between each set of first and second inner electrodes 16 and 18 adjacent each other is made constant. However, the dimension is not required to be constant.

In each of the above-described piezoelectric resonators 10, a single piezoelectric layer 14 is provided between adjacent first and second inner electrodes 16 and 18. However, a plurality of piezoelectric layers may be provided between adjacent first and second inner electrodes 16 and 18.

Further, in each of the above-described piezoelectric resonators 10, the first inner electrode 16 to be connected to the external electrode 20 and the second inner electrode 18 to be connected to the external electrode 22 are alternately formed. However, the first inner electrode 16 and the second inner electrode 18 are not necessarily required to be formed alternately. Further, it is not necessary to form a plurality of first inner electrodes 16 and a plurality of second inner electrodes 18; a single first inner electrode 16 and a single second inner electrode 18 may be formed.

FIG. 19 is a block diagram showing an example of a double-super-heterodyne receiver according to the present invention. The double-super-heterodyne receiver 100 shown in FIG. 19 includes an antenna 102. The antenna 102 is connected to the input of an input circuit 104. The input circuit 104 provides impedance matching between the antenna 102 and a high-frequency amplifier 106, which will be described later. A tuning circuit or a bandpass filter for selecting a desired wave is used in the input circuit 104. The output of the input circuit 104 is connected to the input of the high-frequency amplifier 106. The high-frequency amplifier 106 effects low-noise amplification of weak radio waves in order to improve sensitivity and improves image-frequency selectivity. The output of the high-frequency amplifier 106 is connected to one input of a first frequency mixer 108. The first frequency mixer 108 mixes a desired wave and a first local oscillation wave in order to produce a first intermediate-frequency signal having a frequency corresponding to the sum of or difference between the frequencies of the desired wave and the first local oscillation wave. The output of a first local oscillator 110 is connected to the other input of the first frequency mixer 108. A first local oscillator 110 oscillates the first local oscillation wave for production of the first intermediate-frequency signal. The output of the first frequency mixer 108 is connected to the input of a first bandpass filter 112. The first bandpass filter 112 allows passage of the first intermediate-frequency signal. The output of the first bandpass filter 112 is connected to one input of a second frequency mixer 114. The second frequency mixer 114 mixes the first intermediate-frequency signal and a second local oscillation wave in order to produce a second intermediate-frequency signal having a frequency corresponding to the sum of or difference between the frequencies of the first intermediate-frequency signal and the second local oscillation wave. The output of a second local oscillator 116 is connected to the other input of the second frequency mixer 114. The second local oscillator 116 oscillates the second local oscillation wave for production of the second intermediate-frequency signal. The output of the second frequency mixer 114 is connected to the input of a second bandpass filter 118. The second bandpass filter 118 allows passage of the second intermediate-frequency signal. The output of the second bandpass filter 118 is connected to the input of an intermediate-frequency amplifier 120. The intermediate-frequency amplifier 120 amplifies the second intermediate-frequency signal. The output of the intermediate-frequency amplifier 120 is connected to the input of a detector 122. The detector 122 obtains a signal wave from the second intermediate-frequency signal. The output of the detector 122 is connected to the input of a low-frequency amplifier 124. The low-frequency amplifier 124 amplifies the signal wave to a level sufficient for driving a speaker. The output of the low-frequency amplifier 124 is connected to a speaker 126.

In the double-super-heterodyne receiver 100 according to the present invention, the above-described piezoelectric resonator may be used in the detector 122, and the above-described ladder-type filter may be used in each of the first and second bandpass filters 112 and 118. Thus, the double-super-heterodyne receiver 100 can be made compact and can be provided with excellent receiving characteristics.

Further, according to the present invention, the above-described piezoelectric resonator may be used in a detector of a single-super-heterodyne receiver, and the above-described ladder-type filter may be used in a bandpass filter of the receiver. Such a single-super-heterodyne receiver can be made compact and can be provided with excellent receiving characteristics as in the case of the above-described double-super-heterodyne receiver.

The present invention enables provision of a piezoelectric resonator which can reduce spurious vibrations, which has a large difference between a resonance frequency and an antiresonance frequency, which can be made compact, whose external electrodes are durable, and whose characteristics show substantially no variation.

Further, when an electronic component is fabricated from the piezoelectric resonator according to the present invention, the electronic component can be formed into a chip shape, so that the electronic component can be easily mounted on a circuit board or the like.

Moreover, the present invention provides an electronic component and a communication apparatus, each of which utilizes a piezoelectric resonator which can reduce spurious vibrations, which has a large difference between a resonance frequency and an antiresonance frequency, which can be made compact, whose external electrodes are durable, and whose characteristics show substantially no variation.

While the invention has been particularly shown and described with reference to preferred embodiments thereof, it will be understood by those skilled in the art that the forgoing and other changes in form and details may be made therein without departing from the spirit of the invention.

## Claims

1. A piezoelectric resonator comprising:
a base member having a longitudinal direction;
first and second internal electrodes disposed such that said first and second internal electrodes are separated from each other in the longitudinal direction of said base member and perpendicular to the longitudinal direction of said base member;
a pair of external electrodes disposed on one side surface of said base member and connected to said first and second internal electrodes, one external electrode being located on one transversal side with respect to a transversal center of said base member, and the other external electrode being located on the other transversal side with respect to the transversal center;
said base member comprising a plurality of stacked piezoelectric layers, said piezoelectric layers being polarized in the longitudinal direction of said base member;
each of said first and second internal electrodes being disposed on a surface of said piezoelectric layer perpendicular to the longitudinal direction of said base member;
said first internal electrode connected to one external electrode being provided such that said first inner electrode is not exposed from the one side surface at an area where the other external electrode is disposed;
said second internal electrode connected to the other external electrode being provided such that said second internal electrode is not exposed from the one side surface at an area where said one external electrode is disposed.

2. A piezoelectric resonator according to Claim 1,
characterized in that
g/W ≥ 0,1 being satisfied, where the overall dimension in a direction perpendicular to the main surfaces of said external electrodes is represented by W, and where a dimension of a gap portion where said first and second inner electrodes do not face each other is represented by g, g being measured in a direction perpendicular to the main surfaces of said external electrodes.

3. A piezoelectric resonator comprising:
a base member having a longitudinal direction;
first and second inner electrodes disposed such that said first and second inner electrodes are separated from each other in the longitudinal direction of said base member and perpendicular to the longitudinal direction of said base member;
a pair of external electrodes disposed on two opposite side surfaces of said base member and connected to said first and second inner electrodes;
said base member comprising a plurality of stacked piezoelectric layers, said piezoelectric layers being polarized in the longitudinal direction of said base member;
each of said first and second inner electrodes being disposed on a surface of said piezoelectric layer perpendicular to the longitudinal direction of said base member;
said first inner electrode connected to one external electrode is disposed such that said first inner electrode is not exposed from the two side surfaces at an area where the other external electrode is disposed;
said second inner electrode connected to the other external electrode being disposed such that said second inner electrode is not exposed from the two side surfaces at an area where said one external electrode is disposed.

4. A piezoelectric resonator according to Claim 3,
characterized in that
g/W ≥ 0.05 being satisfied, where the overall dimension in a direction perpendicular to the main surfaces of said external electrodes is represented by W, and where a dimension of a gap portion where said first and second inner electrodes do not face each other is represented by g, g being measured in a direction perpendicular to the main surfaces of said external electrodes.

5. A piezoelectric resonator according to any one of Claims 1 to 4, wherein a plurality of first inner electrodes and a plurality of second inner electrodes are provided.

6. A piezoelectric resonator according to any one of Claims 1 to 5, further comprising a mount member disposed at an approximate center of said base member in the longitudinal direction thereof.

7. An electronic component including the piezoelectric resonator according to Claim 6, wherein
said base member is attached, via said mount member, onto a substrate having an electrode disposed on a surface thereof; and
a cap is disposed on said substrate to cover said base member.

8. An electronic component including the piezoelectric resonator according to any one of Claims 1 to 6 as a parallel resonator of a ladder-type filter.

9. An electronic component according to Claim 7, wherein said electronic component is a ladder-type filter.

10. A communication apparatus including a detector, wherein the piezoelectric resonator according to any one of Claims 1 to 6 is used in said detector.

11. A communication apparatus including a detector, wherein the electronic component according to Claim 7 is used in said detector.

12. A communication apparatus including a bandpass filter, wherein said electronic component according to Claim 8 or 9 is used in said bandpass filter.
